# EUROPEAN PATENT APPLICATION

(11) **EP 4 307 356 A1**
(43) Date of publication of application: **17.01.2024**
(21) Application number: 21938854.3
(22) Date of filing: 26.09.2021
(51) Int. Cl.: H01L 21/768, H01L 23/52

(54) **SEMICONDUCTOR STRUCTURE AND PREPARATION METHOD**

(30) Priority: 28.04.2021 CN 202110469145
(71) Applicant: Changxin Memory Technologies, Inc., Hefei City, Anhui 230000 (CN)
(72) Inventor: LEE, Tzung-han, Hefei, Anhui 230000 (CN); HUANG, Hsin-pin, Hefei, Anhui 230000 (CN)
(74) Representative: Lavoix
(86) International application number: PCT/CN2021/120540
(87) International publication number: WO 2022/227390

(57) **Abstract**

The present application discloses a semiconductor structure and a manufacturing method thereof. The method includes: forming a laminated structure, wherein the laminated structure includes first dielectric layers and second dielectric layers laminated alternately and sequentially from bottom to top; forming a contact hole, wherein the contact hole penetrates the laminated structure at least in a thickness direction, and a width of a part, of the contact hole, in the second dielectric layer is greater than a width of a part, of the contact hole, in the adjacent first dielectric layer; and forming contact structure in the contact hole, wherein the contact structure fills up the contact hole.

## Description

### Cross-Reference to Related Applications

The present application claims the priority to Chinese Patent Application No. 202110469145.6, titled "SEMICONDUCTOR STRUCTURE AND MANUFACTURING METHOD THEREOF", filed with the China National Intellectual Property Administration (CNIPA) on April 28, 2021, which is incorporated herein by reference in its entirety.

### Technical Field

The present application relates to the field of integrated circuit manufacturing, in particular to a semiconductor structure and a manufacturing method thereof.

### Background

With the rapid development of the semiconductor memory technology, the market has higher requirements for the storage capacity of semiconductor memory products. In the back-end-of-line (BEOL) process of manufacturing a dynamic random access memory (DRAM), a plurality of metal layers are electrically connected by using through holes and metal filling structures to complete wafer preparation.

However, the traditionally prepared inter-metal dielectric (IMD) has only a silicon oxide film layer, and the through holes are filled with metal filling structures to electrically connect the metal layers on the upper and lower surfaces of the silicon oxide film layer. After the wafer is prepared, when a reliability test such as the unbiased highly accelerated stress test (UHAST) is performed, under ambient conditions of high temperature and humidity, a single silicon oxide film layer causes the adhesion of the metal filling structures in the through holes to deteriorate. As a result, the metal filling structures fall off, and the prepared wafer severely ages and fails the reliability test.

### Summary

A semiconductor structure and a manufacturing method thereof are provided according to various embodiments of the present application.

According to a first aspect of the present application, a method of manufacturing a semiconductor structure is provided and includes:
forming a laminated structure, wherein the laminated structure includes first dielectric layers and second dielectric layers laminated alternatively and sequentially from bottom to top;
forming a contact hole, wherein the contact hole penetrates the laminated structure at least in a thickness direction, and a width of a part, of the contact hole, in the second dielectric layer is greater than a width of a part, of the contact hole, in an adjacent first dielectric layer; and
forming a contact structure in the contact hole, wherein the contact structure fills up the contact hole.

According to a second aspect of the present application, a semiconductor structure is provided and includes:
a laminated structure, wherein the laminated structure includes first dielectric layers and second dielectric layers laminated alternately and sequentially from bottom to top;
a contact hole, wherein the contact hole penetrates the laminated structure at least in a thickness direction, and a width of a part, of the contact hole, in the second dielectric layer is greater than a width of a part, of the contact hole, in an adjacent first dielectric layer; and
a contact structure, wherein the contact structure fills up the contact hole.

According to the semiconductor structure and the manufacturing method thereof provided in the foregoing embodiments, the method includes: forming the laminated structure including the first dielectric layers and the second dielectric layers laminated alternately and sequentially from bottom to top; forming the contact hole, wherein the contact hole penetrates the laminated structure at least in a thickness direction, and the width of the part, of the contact hole, in the second dielectric layer is greater than a width of the part, of the contact hole, in the adjacent first dielectric layer; and forming the contact structure in the contact hole, wherein the contact structure fills up the contact hole. The first dielectric layers and the second dielectric layers laminated at intervals form a sandwich structure, and the width of the part, of the contact hole, in the second dielectric layer is set greater than the width of the part, of the contact hole, in the adjacent first dielectric layer. Compared with the metal filling structure, in the through hole, obtained by using the traditional technology, the contact structure in the present application has stronger adhesion and improves the reliability and life of the wafer.

The above description is only an overview of the technical solutions of the present application. To understand the technical means of the present application more clearly and implement the technical means according to the content of the specification, the preferred embodiments of the present application are described below in detail with reference to the accompanying drawings.

### Brief Description of the Drawings

To describe the technical solutions in the embodiments of the present application more clearly, the accompanying drawings required to describe the embodiments are briefly described below. Apparently, the accompanying drawings described below are only some embodiments of the present application. A person of ordinary skill in the art may further obtain accompanying drawings of other embodiments based on these accompanying drawings without creative efforts.
FIG. 1 is a schematic flowchart of a method of manufacturing a semiconductor structure according to an embodiment of the present application;
FIG. 2 is a schematic diagram of a partial section of a first metal layer and a laminated structure according to an embodiment of the present application;
FIG. 3 is a schematic diagram of a partial section of an initial contact hole formed in the laminated structure according to an embodiment of the present application;
FIG. 4 is a schematic diagram of a partial section of a contact hole according to an embodiment of the present application;
FIG. 5 is a schematic diagram of a partial section of a contact material layer according to an embodiment of the present application;
FIG. 6 is a schematic diagram of a partial section of a contact structure according to an embodiment of the present application;
FIG. 7 is a schematic diagram of a partial section of a metal material layer according to an embodiment of the present application;
FIG. 8 is a schematic diagram of a partial section of a second metal layer according to an embodiment of the present application;
FIG. 9 is a schematic diagram of a partial section of a contact hole according to another embodiment of the present application; and
FIG. 10 is a schematic diagram of a partial section of a semiconductor structure according to an embodiment of the present application.

### Detailed Description

To facilitate the understanding of the present application, the present application is described more completely below with reference to the accompanying drawings. The preferred embodiments of the present application are shown in the accompanying drawings. However, the present application may be embodied in various forms without being limited to the embodiments described herein. On the contrary, these embodiments are provided to make the present application more thorough and comprehensive.

Unless otherwise defined, all technical and scientific terms used herein have the same meaning as commonly understood by those skilled in the technical field of the present application. The terms mentioned herein are merely for the purpose of describing specific embodiments, rather than to limit the present application. The term "and/or" used herein includes any and all combinations of one or more of the associated listed items.

It should be understood that when an element or layer is described as "being on", "being adjacent to", "being connected to" or "being coupled to" another element or layer, it can be on, adjacent to, connected to, or coupled to the another element or layer directly, or intervening elements or layers may be present. On the contrary, when an element is described as "being directly on", "being directly adjacent to", "being directly connected to" or "being directly coupled to" another element or layer, there are no intervening elements or layers. It should be understood that although terms such as first, second, and third may be used to describe various elements, components, regions, layers and/or sections, these elements, components, regions, layers and/or sections should not be limited by these terms. These terms are only used to distinguish one element, component, region, layer or section from another element, component, region, layer or section. Therefore, without departing from the teachings of the present application, the first element, component, region, layer or section discussed below may a second element, component, region, layer or section.

Spatial relationship terms such as "under", "beneath", "lower", "below", "above", and "upper" can be used herein to conveniently describe the relationship shown in the figure between one element or feature and another element or feature. It should be understood that in addition to the orientations shown in the figure, the spatial relationship terms are intended to further include different orientations of used and operated devices. For example, if a device in the accompanying drawings is turned over, and then described as being "beneath another element", "below it", or "under it", the device or feature is oriented "on" the another element or feature. Therefore, the exemplary terms "beneath" and "under" may include two orientations of above and below. The device may be otherwise oriented (rotated by 90 degrees or other orientations), and the spatial description used herein is interpreted accordingly.

The purpose of the terms used herein is only to describe specific embodiments instead of being a limitation of the present application. In this specification, the singular forms of "a", "an" and "the/this" also include plural forms, unless clearly indicated otherwise. It should also be understood that terms "include" and/or "comprise", when used in this specification, determine the presence of features, integers, steps, operations, elements and/or components, but do not exclude the presence or addition of one or more other features, integers, steps, operations, elements, components and/or groups. In this specification, the term "and/or" includes any and all combinations of related listed items.

The embodiments of the present application are described herein with reference to cross-sectional views as schematic diagrams of the embodiments (and intermediate structures) of the present application. In this way, changes from the shown shape due to, for example, the manufacturing technology and/or tolerances can be expected. Therefore, the embodiments of the present application should not be limited to the specific shapes of the regions shown herein, but include shape deviations due to, for example, manufacturing. The regions shown in the figure are schematic in nature, and their shapes are not intended to show the actual shapes of the regions of the device and limit the scope of the present application.

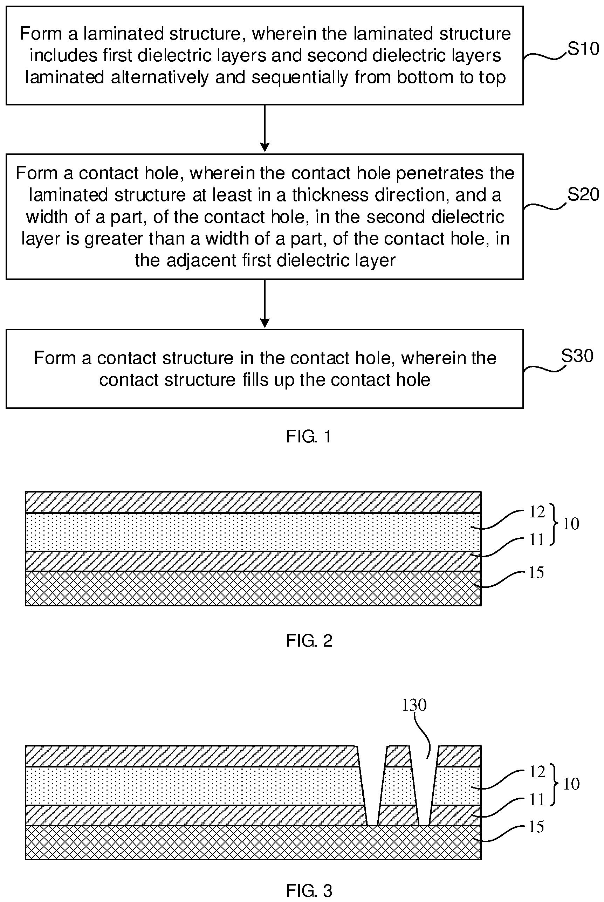

As shown in FIG. 1, an embodiment of the present application provides a method of manufacturing a semiconductor structure, including:
step S10. Form a laminated structure 10, wherein the laminated structure 10 includes first dielectric layers 11 and second dielectric layers 12 laminated alternatively and sequentially from bottom to top.
step S20. Form a contact hole 13, wherein the contact hole penetrates the laminated structure 10 at least in a thickness direction, and a width of a part, of the contact hole 13, in the second dielectric layer 12 is greater than a width of a part, of the contact hole 13, in the adjacent first dielectric layer 11.
step S30. Form a contact structure 14 in the contact hole 13, wherein the contact structure 14 fills up the contact hole 13.

The method of manufacturing a semiconductor structure provided in the foregoing embodiments includes: forming the laminated structure including the first dielectric layers and the second dielectric layers laminated alternately and sequentially from bottom to top; forming the contact hole, wherein the contact hole penetrates the laminated structure at least in a thickness direction of the laminated structure, and the width of the part, of the contact hole, in the second dielectric layer is greater than the width of the part, of the contact hole, in the adjacent first dielectric layer; and forming the contact structure in the contact hole, wherein the contact structure fills up the contact hole. The first dielectric layers and the second dielectric layers laminated at intervals form a multi-layer structure including at least two layers, and the width of the part, of the contact hole, in the second dielectric layer is set greater than the width of the part, of the contact hole, in the adjacent first dielectric layer. Compared with the metal filling structure, in the through hole, obtained by using the traditional technology, the contact structure in the present application has stronger adhesion and improves the reliability and life of the DRAM wafer.

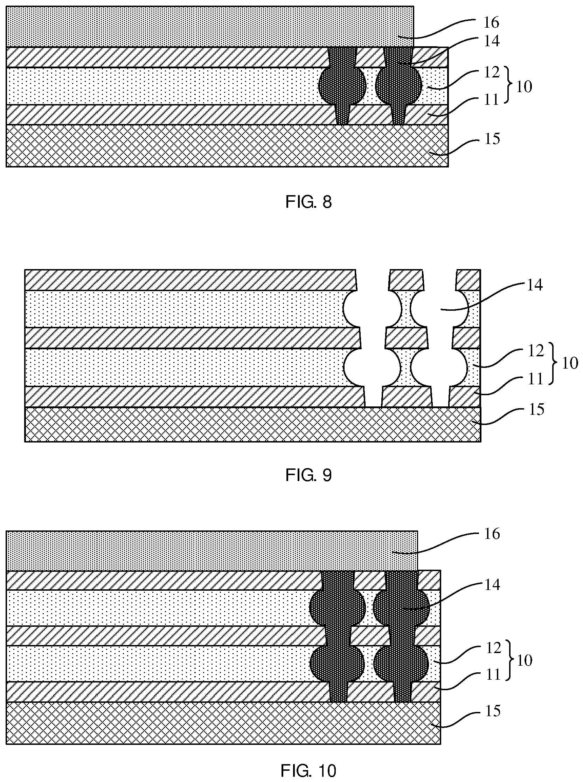

In an embodiment, as shown in FIG. 2, before step S10 of forming the laminated structure 10, the method further includes: forming a first metal layer 15, wherein the laminated structure 10 is formed on an upper surface of the first metal layer 15. For example, a material of the first metal layer 15 includes but is not limited to one of tungsten, copper, or aluminum or an alloy material of any combination thereof. The laminated structure 10 provided in step S10 is of a sandwich structure. The second dielectric layer 12 is located between adjacent first dielectric layers 11, that is, a three-layer structure: the first dielectric layer 11, the second dielectric layer 12, and the first dielectric layer 11. In addition to the laminated structure in FIG. 2, the laminated structure 10 further includes a plurality of the first dielectric layers 11 and the second dielectric layers 12 laminated alternatively and sequentially. A bottom layer and a top layer of the laminated structure 10 are both the first dielectric layers 11. With reference to FIG. 9, the laminated structure 10 includes five layers in total, namely, the first dielectric layer 11, the second dielectric layer 12, the first dielectric layer 11, the second dielectric layer 12, and the first dielectric layer 11. Certainly, the shown laminated structure is not limited thereto, and may also include 7 or 9 layers, and the like. The quantity of layers and contact structure of the laminated structure may be adjusted according to the actual requirements of wafer preparation.

In an embodiment, the hardness of the first dielectric layer 11 is different from the hardness of the second dielectric layer 12, and their densities are different either, so that a stable and relatively adhesive contact structure is formed subsequently. Specifically, the first dielectric layer 11 includes a silicon nitride layer, and the second dielectric layer 12 includes a silicon oxide layer. The hardness of the first dielectric layer 11 may be greater than the hardness of the second dielectric layer 12. After the contact structure is formed, relatively large stresses are likely to generate at both ends of the contact structure. Using a material with a relatively large hardness as the first dielectric layer 11 can avoid that the medium layer at both ends of the contact structure deform, thereby improving the stability of the contact structures.

For example, a longitudinal cross-sectional shape of a part, of the contact structure 14, in the first dielectric layer 11 is an inverted trapezoid, and edges, in contact with the second dielectric layer 12, of a longitudinal cross-sectional shape of the part that is of the contact structure 14 and that is in the second dielectric layer 12, are arc-shaped.

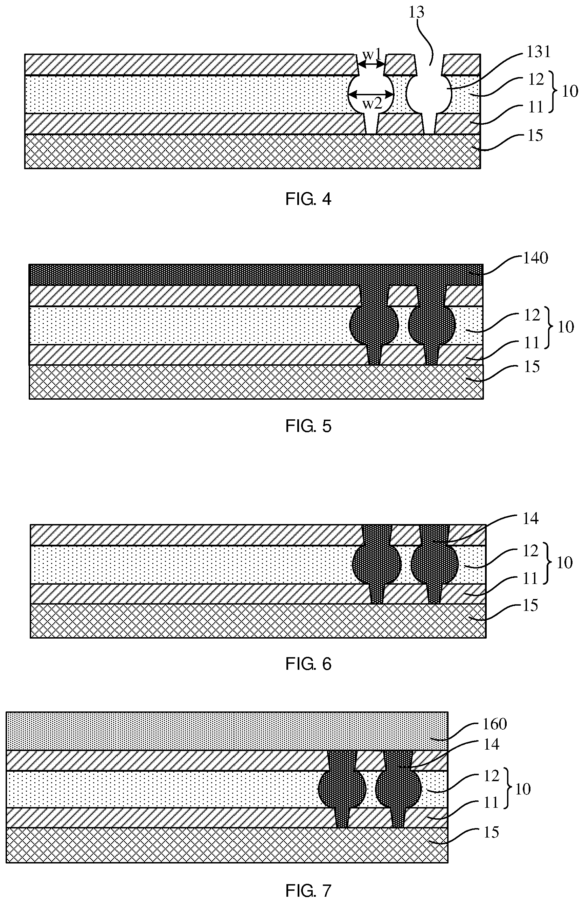

In an embodiment, step S20 of forming the contact holes 13 includes:
step S21. Form an initial contact hole 130 in the laminated structure 10, as shown in FIG. 3.
step S22. Etch the exposed second dielectric layer 12 laterally based on the initial contact hole 130, and form a groove 131 in corresponding region of part, of the contact hole 130, in the second dielectric layer 12, so that the width of the part, of the contact hole 13, in the second dielectric layer 12 is greater than the width of the part, of the contact hole 13, in the adjacent first dielectric layer 11, as shown in FIG. 4.

Specifically, in step S22, the exposed second dielectric layer 12 may be etched laterally by using a wet etching process with a high etch selectivity. An etch selectivity of the second dielectric layer 12 to the first dielectric layer is greater than 1, to ensure that the etchant does not affect the first dielectric layer 11 while the second dielectric layer 12 is etched to form the groove.

For example, the longitudinal cross-sectional shape of the formed initial contact hole 130 is an inverted trapezoid, and the sidewalls of the initial contact hole 130 are inclined at an angle of 5° to 10° with respect to the direction perpendicular to the upper surface of the laminated structure 10. Specifically, the inclination angles are 5°, 6°, 7°, 8°, 9°, 10°, and the like. The width of the part, of the contact hole 13, in the second dielectric layer 12 is referred to as w2, and the width of the part, of the contact hole 13, in the adjacent first dielectric layer 11 is referred to as w1, and w2 > w1. The groove 131 formed in corresponding region of part, of the contact hole 130, in the second dielectric layer 12 are similar to latch notches to fix the formed contact structure in the laminated structure 10, increase the adhesion force, and avoid the separation of the contact structure.

In an embodiment, step S30 of forming the contact structure 14 in the contact hole 13 includes:
step S31. Form a contact material layer 140 in the contact hole 13 and on an upper surface of the laminated structure 10, as shown in FIG. 5.
step S32. Remove the contact material layer 140 on the upper surface of the laminated structure 10, and retain the contact material layer 140 in the contact hole 13 as the contact structure 14, as shown in FIG. 6.

Specifically, a dry etching process or a chemical mechanical polishing process is used to remove the contact material layer 140 on the upper surface of the laminated structure 10, and retain the contact material layer 140 as the contact structure 14 of which the upper surface are flush with the upper surface of the first dielectric layer 10 as the top surface.

For example, a material of the contact material layer 140 may include but is not limited to one of tungsten, copper, or aluminum or an alloy material of any combination thereof.

In an embodiment, after step S30 of forming the contact structure 14, the method further includes: step S40. Form a second metal layer 16 on the laminated structure 10, wherein the second metal layer 16 is in contact with a top of the contact structure 14, the first metal layer 15 is in contact with a bottom of the contact structure 14, and the second metal layer 16 is connected to the first metal layer 15 by using the contact structure 14.

For example, a material of the second metal layer 16 includes but is not limited to one of tungsten, copper, or aluminum or an alloy material of any combination thereof.

In an embodiment, step S40 of forming the second metal layer 16 on the laminated structure 10 includes:
step S41. Form a metal material layer 160 on an upper surface of the contact structure 14 and on the laminated structure 10, as shown in FIG. 7.
step S42. Pattern the metal material layer 160 to obtain the second metal layer 16, as shown in FIG. 8.

In addition to the foregoing embodiments, as shown in FIG. 9 and FIG. 10, the laminated structure 10 may further include the first dielectric layer 11, the second dielectric layer 12, the first dielectric layer 11, the second dielectric layer 12, and the first dielectric layer 11. The contact hole 13 in the two second dielectric layers 12 includes a plurality of grooves. Based on the forming the contact structures 14 and forming the second metal layer 16, the contact structure 14 is formed in the contact hole 13, and the second metal layer 16 is formed on the laminated structure 10.

In an embodiment of the present application, with reference to FIG. 8 and FIG. 10, and a semiconductor structure is also provided, including:
a laminated structure 10, wherein the laminated structure 10 includes first dielectric layers 11 and second dielectric layers 12 laminated alternately and sequentially from bottom to top;
a contact hole 13, wherein the contact hole 13 penetrates the laminated structure 10 at least in a thickness direction, and a width of a part, of the contact hole 13, in the second dielectric layer 12 is greater than a width of a part, of the contact hole 13, in the adjacent first dielectric layer 11; and
a contact structure 14, wherein the contact structure 14 fills up the contact hole 13.

In an embodiment, the materials of the second dielectric layer 12 and the first dielectric layer 11 are different. Specifically, the hardness of the first dielectric layer 11 is different from the hardness of the second dielectric layer 12, and their densities are different either, so that stable and relatively adhesive contact structure is formed subsequently. The first dielectric layer 11 includes a silicon nitride layer, and the second dielectric layer 12 includes a silicon oxide layer.

In an embodiment, the laminated structure 10 includes a plurality of the first dielectric layers 11 and the second dielectric layers 12 laminated alternately and sequentially, and a bottom layer and a top layer of the laminated structure 10 are both the first dielectric layers 11.

In an embodiment, a longitudinal cross-sectional shape of a part, of the contact structure 14, in the first dielectric layer 11 is an inverted trapezoid, and edges, in contact with the second dielectric layer 12, of a longitudinal cross-sectional shape of the part that is of the contact structure 14 and that is in the second dielectric layer 12, are arc-shaped.

In the semiconductor structure provided in the foregoing embodiments, the laminated structure includes the first dielectric layers and the second dielectric layers laminated alternately and sequentially from bottom to top; the contact hole penetrates the laminated structure at least in a thickness direction, and the width of the part, of the contact hole, in the second dielectric layer is greater than the width of the part, of the contact hole, in the adjacent first dielectric layer; and the contact structure fills up the contact hole. The first dielectric layers and the second dielectric layers laminated at intervals form a sandwich structure, and the width of the part, of the contact hole, in the second dielectric layer is set greater than the width of the part, of the contact hole, in the adjacent first dielectric layer. Compared with the metal filling structure, in the through hole, obtained by using the traditional technology, the contact structure in the present application has stronger adhesion and improves the reliability and life of the wafer.

It may be noted that the foregoing embodiments are merely for the purpose of description instead of limiting the present application.

It should be understood that the execution order of the steps is not strictly limited, and the steps may be executed in other orders, unless clearly described otherwise. Moreover, at least some of the steps may include a plurality of sub-steps or stages. The sub-steps or stages are not necessarily executed at the same time, but may be executed at different times. The execution order of the sub-steps or stages is not necessarily carried out sequentially, but may be executed alternately with other steps or at least some of the sub-steps or stages of other steps.

The embodiments of this specification are described in a progressive manner, and each embodiment focuses on differences from other embodiments. The same or similar parts between the embodiments may refer to each other.

The technical characteristics of the above examples can be employed in arbitrary combinations. To provide a concise description of these examples, all possible combinations of all technical characteristics of the embodiment may not be described; however, these combinations of technical characteristics should be construed as disclosed in the description as long as no contradiction occurs.

## Claims

1. A method of manufacturing a semiconductor structure, comprising:
forming a laminated structure, wherein the laminated structure comprises first dielectric layers and second dielectric layers laminated alternately and sequentially from bottom to top;
forming a contact hole, wherein the contact hole penetrates the laminated structure at least in a thickness direction, and a width of a part, of the contact hole, in the second dielectric layer is greater than a width of a part, of the contact hole, in an adjacent first dielectric layer; and
forming a contact structure in the contact hole, wherein the contact structure fills up the contact hole.

2. The method of manufacturing a semiconductor structure according to claim 1, wherein the forming a contact hole comprises:
forming an initial contact hole in the laminated structure; and
etching an exposed second dielectric layer laterally based on the initial contact hole, and forming a groove in corresponding region of part, of the contact hole, in the second dielectric layer, so that the width of the part, of the contact hole, in the second dielectric layer is greater than the width of the part, of the contact hole, in the adjacent first dielectric layer.

3. The method of manufacturing a semiconductor structure according to claim 2, wherein the exposed second dielectric layer is etched laterally by using a wet etching process.

4. The method of manufacturing a semiconductor structure according to claim 2, wherein an etch selectivity of the second dielectric layer to the first dielectric layer is greater than 1.

5. The method of manufacturing a semiconductor structure according to claim 1, wherein the forming a contact structure in the contact hole comprises:
forming a contact material layer in the contact hole and on an upper surface of the laminated structure; and
removing the contact material layer on the upper surface of the laminated structure, and retaining the contact material layer in the contact hole as the contact structure.

6. The method of manufacturing a semiconductor structure according to claim 5, wherein the contact material layer on the upper surface of the laminated structure is removed by using a dry etching process or a chemical mechanical polishing process.

7. The method of manufacturing a semiconductor structure according to claim 1, wherein the first dielectric layer comprises a silicon nitride layer, and the second dielectric layer comprises a silicon oxide layer.

8. The method of manufacturing a semiconductor structure according to claim 1, wherein the laminated structure comprises a plurality of the first dielectric layers and the second dielectric layers laminated alternatively and sequentially, and a bottom layer and a top layer of the laminated structure are both the first dielectric layers.

9. The method of manufacturing a semiconductor structure according to any one of claims 1 to 8, before the forming a laminated structure, furthering comprising: forming a first metal layer, wherein the laminated structure is formed on an upper surface of the first metal layer; and after the forming a contact structure, further comprising: forming a second metal layer on the laminated structure, wherein the second metal layer is in contact with a top of the contact structure, the first metal layer is in contact with a bottom of the contact structure, and the second metal layer is connected to the first metal layer by using the contact structure.

10. The method of manufacturing a semiconductor structure according to claim 9, wherein the forming a second metal layer on the laminated structure comprises:
forming a metal material layer on an upper surface of the contact structure and on the laminated structure; and
patterning the metal material layer to obtain the second metal layer.

11. A semiconductor structure, comprising:
a laminated structure, wherein the laminated structure comprises first dielectric layers and second dielectric layers laminated alternately and sequentially from bottom to top;
a contact hole, wherein the contact hole penetrates the laminated structure at least in a thickness direction, and a width of a part, of the contact hole, in the second dielectric layer is greater than a width of a part, of the contact hole, in an adjacent first dielectric layer; and
a contact structure, wherein the contact structure fills up the contact hole.

12. The semiconductor structure according to claim 11, wherein materials of the second dielectric layer and the first dielectric layer are different.

13. The semiconductor structure according to claim 11, wherein the laminated structure comprises a plurality of the first dielectric layers and the second dielectric layers laminated alternately and sequentially, and a bottom layer and a top layer of the laminated structure are both the first dielectric layers.

14. The semiconductor structure according to claim 11, wherein the first dielectric layer comprises a silicon nitride layer, and the second dielectric layer comprises a silicon oxide layer.

15. The semiconductor structure according to any one of claims 11 to 14, wherein a longitudinal cross-sectional shape of a part, of the contact structure, in the first dielectric layer is an inverted trapezoid, and edges, in contact with the second dielectric layer, of a longitudinal cross-sectional shape of the part that is of the contact structure and that is in the second dielectric layer, are arc-shaped.
